# EUROPEAN PATENT SPECIFICATION

(11) **EP 4 355 065 B1**
(45) Date of publication and mention of the grant of the patent: **14.05.2025**
(21) Application number: 22200935.9
(22) Date of filing: 11.10.2022
(51) Int. Cl.: H10N 60/12, G06N 10/40

(54) **PLANAR ELECTRICALLY FLOATING QUBIT CIRCUIT STRUCTURE**
PLANARE ELEKTRISCH SCHWEBENDE QUBIT-SCHALTUNGSSTRUKTUR
STRUCTURE DE CIRCUIT QUBIT PLANAIRE ÉLECTRIQUEMENT FLOTTANT

(43) Date of publication of application: 17.04.2024
(73) Proprietor: Forschungszentrum Jülich GmbH, 52425 Jülich (DE)
(72) Inventor: Barends, Rami, Heerlen (NL)
(74) Representative: Leinweber & Zimmermann

(56) References cited:
- WO-A1-2019/179731
- JP-A- 2022 126 641
- US-A1- 2022 293 844
- HOUCK A A ET AL: "Life after charge noise: recent results with transmon qubits", ARXIV.ORG, CORNELL UNIVERSITY LIBRARY, 201 OLIN LIBRARY CORNELL UNIVERSITY ITHACA, NY 14853, 10 December 2008 (2008-12-10), XP080352376, DOI: 10.1007/S11128-009-0100-6

## Description

The invention relates to a planar electrically floating qubit circuit structure comprising a Josephson junction region including first and second weakly coupled superconductors; first and second electrode regions galvanically coupled to said first and second superconductors, respectively; and a ground electrode region.

Quantum circuits including a Josephson junction having a self-capacitance and an external shunt capacitance connected thereacross are generally known. In particular, transmon qubits that are currently widely used are generally implemented using a dominant direct capacitor in parallel with either a single Josephson junction for fixed-frequency qubits, or two Josephson junctions in a superconducting quantum interference device (SQUID) geometry. These qubits are straight forward to build, however, they suffer from a lack of coherence.

To remedy the coherence problem, it has been a conventional approach to use extended, large capacitors directly connected across the superconductors of the Josephson junction. In this case, the electric fields are low so that individual coupling to defects in the capacitive area is minimised. This can, however, induce parasitic couplings in large systems. Moreover, using such large capacitors complicates implementing coupling schemes between qubits, resonators, and other elements, due to the size needed for coupling capacitors.

An article entitled "Merged-element transmon" published by R. Zhao, S. Park, T. Zhao, M. Bal, C.R.H. McRae, J. Long, and D.P. Pappas (Phys. Rev. Applied 14, 064006 (2020)) proposes to implement the circuit structure by engineering the Josephson junction self-capacitance to be large enough to act as its own shunt capacitor, thereby eliminating the need for the external direct capacitor.

Further arrangements of the prior art are described in US 2022 / 0293844 A1, WO 2019 / 179731 A1, JP 2022-126641 A and A.A. Houck et al., "Life after charge noise: recent results with transmon qubits", arXiv:0812.1865v1[cond-mat.mes-hall], p. 1-6, (2008).

It is an object of the present invention to propose an alternative implementation of a qubit circuit structure of the above referenced type.

In order to attain this object, a circuit structure of the above referenced type is implemented with the series capacitance of said first and second electrode regions to said ground electrode region being greater than the self-capacitance of said Josephson junction region.

In the planar circuit structure of the invention, the first and second electrode regions are mutually galvanically isolated and each of them is also galvanically isolated from the coplanar ground electrode. In particular, the isolation is effected by an isolation zone that is free from electrode material and is located between the ground electrode region and the first and second electrode regions so as to physically separate them from each other. This is preferably realised by a thin metallisation layer formed on the plain surface of an underlying substrate and having cut-outs formed therein that spatially separate the ground electrode region and the first and second electrode regions from each other. In particular, these cut-outs are in the shape of thin strips that are free of metallisation material.

In this configuration, capacitances between the ground electrode region and the first and second electrode regions, respectively, form a series capacitance that shunts the self-capacitance of the Josephson junction region. The capacitance value of this arrangement may be calculated in accordance with a method disclosed in arXiv:1410.3458 entitled "Calculation of Coupling Capacitance in Planar Electrodes".

The circuit structure according to the invention is configured so as to result in a value of the series capacitance that is greater than the value of the self-capacitance of the Josephson junction region. In practice, the proportion of the self-capacitance in the total capacitance may be not more than 40 %, preferably not more than 30 %, or 20 % or even 10 %.

As compared to prior art using a dominant direct capacitor in parallel with a Josephson junction, the circuit structure according to the invention results in better coherence. There is less coupling to individual dipole defects (as for instance described in an article by J.M. Martinis, K.B. Cooper, R. McDermott, M. Steffen, M. Ansmann, K.D. Osborn, K. Cicak, S. Oh, D.P. Pappas, R.W. Simmonds, and C.C. Yu, Phys. Rev. Lett. 95, 210503 (2005) entitled "Decoherence in Josephson Qubits from Dielectric Loss"), as it requires more ground capacitance and hence less electrical field strength. It is easier to implement coupling to drivelines, qubits or other elements, as the implementation has longer traces. In addition, parasitic crosstalk to other qubits is reduced. Larger distance between the qubits means that qubits are farther away from the other qubits "centre of mass". Further, parasitic coupling and related loss to other grounds and metals on other planes for 3D-integrating systems is reduced thanks to the direct capacitance to ground. The circuit structure according to the invention can be straight forwardly implemented using waveguides, and the parasitic inductance is small.

The invention is not limited to qubit circuit structures comprising a single Josephson junction for fixed-frequency qubits but in particular also applies to circuit structures having two Josephson junctions in a superconducting quantum interference device (SQUID) geometry.

In particular, the surface area of the Josephson junction region is less than the surface area of each of the first and second electrode regions. Preferably, each of the first and second electrode regions is bonded by two curve segments that extend between a first point that is nearest to the Josephson junction region and a second point that is remotest from the Josephson junction region, and for each point on a bisector curve that extends between the two curve segments from the first to the second point, a distance between the two curve segments measured along a transversal straight line orthogonally intersecting the bisector curve in that point is not substantially increased when the distance of that intersection point from the Josephson junction region is decreased. This is very different from standard qubit designs which feature large electrode pads in the centre of the circuit structure.

In preferred embodiments, the geometrical arrangement of said first and second electrode regions is centrally symmetric with respect to the centroid of the surface area of said Josephson junction region. This point symmetric geometry maintains the electrical "centre of mass" and minimises parasitics from asymmetry.

In other expedient designs, each of said first and second electrode regions is in the shape of a continuous strip of essentially uniform width that extends between a connecting portion thereof, that is located adjacent to said Josephson junction region for galvanic connection thereto and at least one free end portion thereof, that is located remote from said Josephson junction region. In these designs, the before-mentioned bisector curve may in particular be a straight line, a line composed of straight line sections, a meandering line and/or combinations thereof. The longitudinal edges of the strip extend along the bisector curve on both sides thereof at a uniform distance. From these edges of the strip, neighbouring edges of the ground electrode region are preferably equidistantly spaced at a small distance. The transverse edge that connects the longitudinal edges of the strip at an end portion thereof is preferably at the same distance away from the corresponding neighbouring edge of the ground plain.

In a preferred embodiment, said strip has first and second free end portions with said connecting portion of said strip located half-way therebetween. Especially preferably, the directions of extension of said strip from its connecting portion to its first and second free end portions are essentially mutually orthogonal. In the latter case, the connecting portion of the strip is expediently formed as a short strip section whose bisector curve extends in a direction that is orthogonal to the angular bisector of the two orthogonal directions of strip extension. Specifically, as already stated earlier, the connecting portion may have one, two or even more Josephson junctions connected thereto. One of the benefits of this design is its increased compactness.

In any of the above realisations of the first and second electrode regions that may be described as having the connecting portion located between legs extending therefrom, it is to be understood that instead of two open-ended legs as described above, in principle more legs can be added, depending on the need for coupling to other elements or drivelines.

In particular, said direction of extension of said strip is a mean linear direction, said strip meandering about said linear direction between said connecting portion thereof and each one of said free end portions thereof.

According to another aspect of the invention, said ground electrode region and each of said first and second electrode regions is arranged so as to form a microstrip waveguide, or as an alternative, said ground electrode region and each of said first and second electrode regions is arranged so as to form a coplanar waveguide. Other waveguide geometries that include direct capacitance to ground are possible.

The qubit circuit structure according to the invention may in particular be implemented as a fixed-frequency transmon, specifically including one single Josephson junction, or as a tuneable transmon, specifically including two Josephson junctions.

In a further aspect, a circuit structure according to the invention is combined with a tuneable coupler and another circuit structure according to the invention so that at least one of said first and second electrode regions of the one of said circuit structures is capacitively coupled to the tuneable coupler that is capacitively coupled to one of said first and second electrode regions of the other one of said circuit structures.

In the following, exemplary embodiments of the invention will be described with reference to the drawings, in which:
- Figs. 1(a) and (b): show a schematic circuit diagram of a fixed-frequency implementation using a single Josephson junction and a tuneable-frequency implementation using a SQUID, respectively, in accordance with the invention;
- Figs. 2(a) to (I): schematically illustrate various geometric shapes of first and second electrode regions galvanically coupled to Josephson junction regions;
- Figs. 3(a), (b) and (c): illustrate the schematic geometric shape according to Fig. 2a, a corresponding schematic circuit diagram and a more detailed plan view of an example implementation, respectively; and
- Figs. 4(a) and 4(b): illustrate a comparison between standard qubit circuits using a dominant direct capacitor between electrodes and embodiments according to the invention.

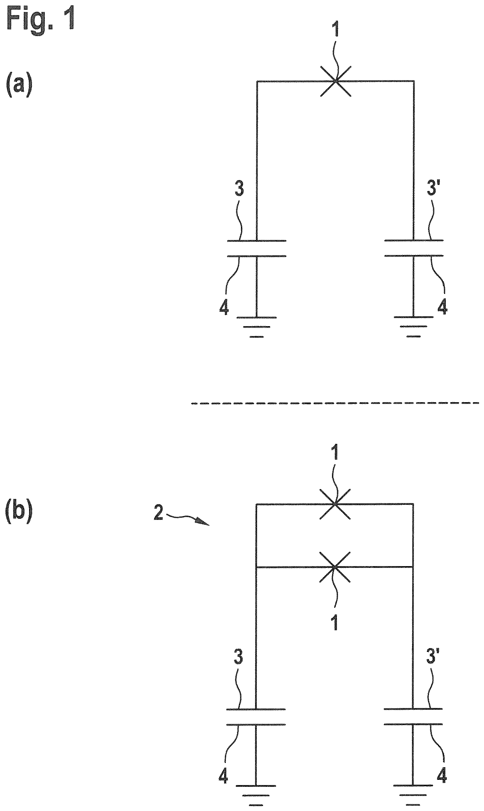

In the circuit diagrams of Figs 1(a) and (b), a cross symbol stands for a Josephson junction region 1 including first and second weakly coupled superconductors. The Josephson junction 1 of Fig. 1(a) or a SQUID-loop 2 composed of the two Josephson junctions 1 in Fig. 1(b) are each galvanically coupled to first and second electrode regions 3, 3' that are symbolised by each one of the capacitor plates of two capacitors. The opposite ones 4 of the two capacitor plates 3, 3' are to symbolise a common ground electrode region 4. The first and second electrode regions 3, 3' thereby imply a series capacitance to the ground electrode region 4. The first and second electrode regions 3, 3' and the ground electrode region 4 are in a coplanar configuration that is arranged and dimensioned so as to have a series capacitance greater than the self-capacitance of the Josephson junction region 1 or SQUID-loop 2, respectively.

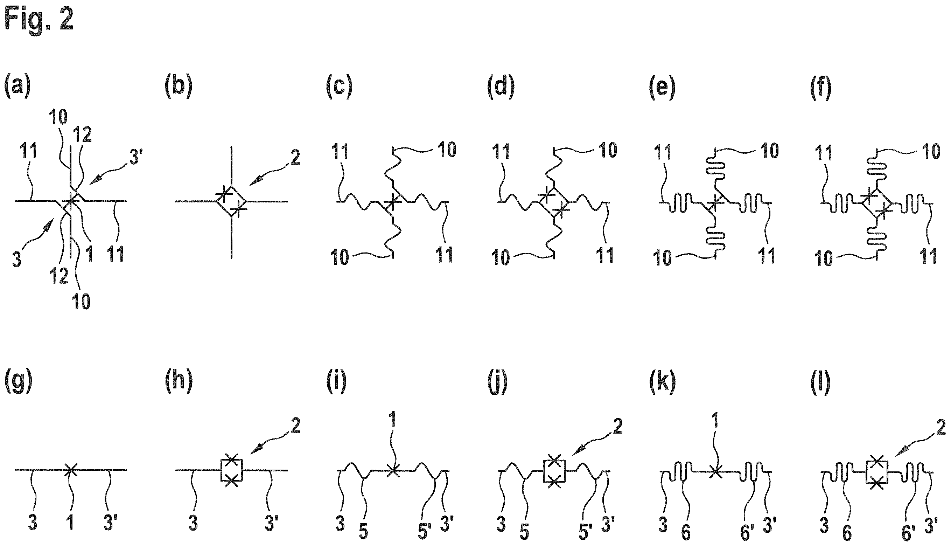

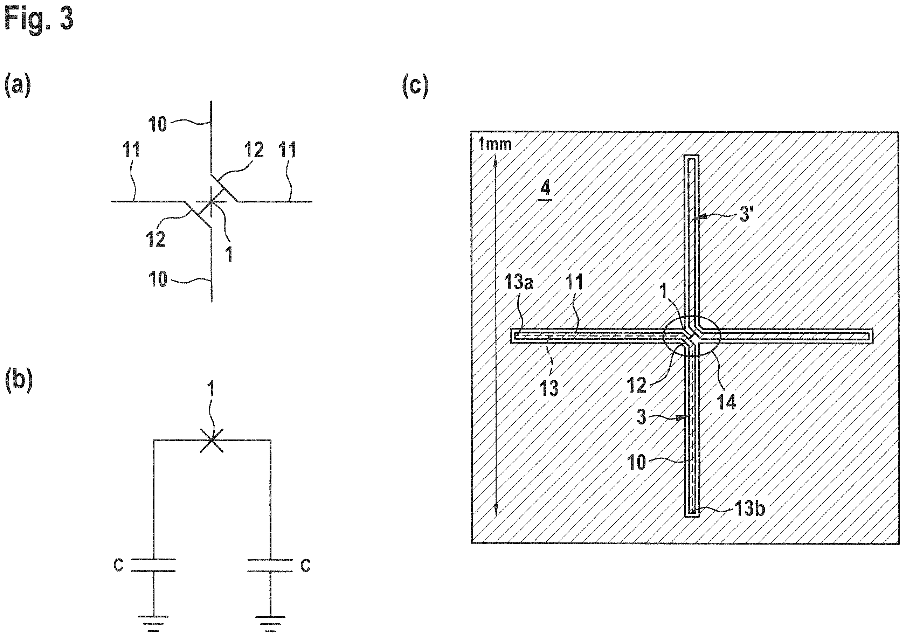

Figs 2(a) to (l) illustrate various types of geometric shapes of the first and second electrode regions 3, 3' that may expediently be used to implement the invention. The coplanar ground electrode region is not indicated in this illustration but may be imagined to fill the remaining area of each of the implementations so as to leave some gap to the first and second electrode regions 3, 3' as well as the Josephson junction region 1. A more detailed illustration of this situation will be discussed later with reference to Fig. 3(c).

In the embodiment illustrated in Fig. 2(g) each of the first and second electrode regions 3, 3' is in the shape of a rectilinear strip of identical width and length having one end thereof galvanically connected to the Josephson junction region 1 and the opposite end being open. Fig. 2(h) illustrates a similar geometry and is only different from Fig. 2(g) in that the connection is to a SQUID-loop 2 instead of a single Josephson junction 1. The embodiments of Figs. 2(i) and (j) correspond to the ones of Figs 2(g) and (h), respectively, however, with the difference that the strips 3, 3' are not rectilinear but each include an intermediate section 5, 5' of a sine wave-like shape. The embodiments of Figs 2(k) and (l) are similar to the ones of Figs 2(i) and (j), respectively, however, with the difference that the sine wave-like intermediate sections 5, 5' are replaced by intermediate sections 6, 6', each of which meanders over a length of two periods of a waveform composed of essentially transverse rectilinear sections intermittently connected by rounded arcs at their ends. As can be seen from the drawings, each of the embodiments of Figs. 2(g) to 2(I) have a centrally symmetric design with respect to the centroid of the surface area of the Josephson junction region 1 or SQUID-loop region 2, respectively.

As may be taken from Fig. 2, each of the above-described embodiments illustrated in Figs. 2(g) to (l) may generally be described to have a Josephson junction 1 or a SQUID-loop 2 in the centre thereof and two rectilinear or meandering legs 3, 3' extending from the centre in opposite directions. In contrast, in each of the embodiments illustrated in Fig. 2(a) to (f) each of the first and second electrode regions 3, 3' comprises a pair of legs 10, 11 and a connecting portion 12 linking the legs 10, 11 in the neighbourhood of the Josephson junction region 1 or SQUID-loop area 2. The legs 10, 11 of each pair extend in mutually orthogonal directions. Otherwise, the shape of the legs 10, 11 in Figs 2(a) to (f) is similar to the shape of the first and second electrode regions 3, 3' illustrated in Figs 2(g) to (l). Thereby, each of the embodiments of Figs 2(a) to 2(f) is again centrally symmetric with respect to the centroid of the surface area of the Josephson junction region 1 or the SQUID-loop region 2, respectively.

Fig. 3 shows an embodiment according to Fig. 2(a) in more detail, with Fig. 3(a) schematically illustrating the geometry, Fig. 3(b) illustrating the equivalent circuit diagram and Fig. 3(c) illustrating the circuit layout in an enlarged scale. As may be seen from Fig. 3(c), the legs 10, 11 and the connection portion (12) of the first and second electrode regions 3, 3' extend at an essentially constant transverse width along a bisector curve 13 that is marked as a dotted line in the first electrode region 3 that extends in the lower left portion of Fig. 3(c), while the same, although not explicitly drawn-in, also applies to the second electrode region 3' extending in the upper right portion of Fig. 3(c). This bisector curve 13 extends from a left outermost point 13a towards a central portion that is indicated by circle 14 and then again towards a lower outermost point 13b. The Josephson junction region 1 is located centrally within circle 14 and covers a surface area that is much smaller than the surface area covered by the first and second electrode regions 3, 3'. The first and second electrode regions 3, 3' are centrally symmetric with respect to the centroid of the surface area of the Josephson junction 1 so that the foregoing description of the first electrode region 3 applies accordingly.

As may be further seen from Fig. 3(c), the Josephson junction region 1 is galvanically connected to the first and second electrode regions 3, 3' where the respective connecting portions 12 are closest thereto. While the portions of the bisector curve 13 that extend from the outermost points 13a, 13b towards the central portion 14 are mutually orthogonal, the section of the bisector curve 13 within the connecting portion 12 is orthogonal to the angular bisecting line between the two orthogonal sections of bisector curve 13.

The above described first and second electrode regions 3, 3' are illustrated in Fig. 3(c) as hatched areas of metallisation. The remaining hatched area of Fig. 3(c) indicates the metallised ground electrode region 4. It is separated from the first and second electrode regions 3, 3' by a small transverse gap 15 that extends into the area limited between the facing edges of the connecting portions 12 of the first and second electrode regions 3, 3' and is free from any metallisation. Because of the centrally symmetric configuration, capacitances defined between the ground electrode region 4 and the first and second electrode regions 3, 3', respectively, are identical and are indicated as "C" in Fig. 3(b).

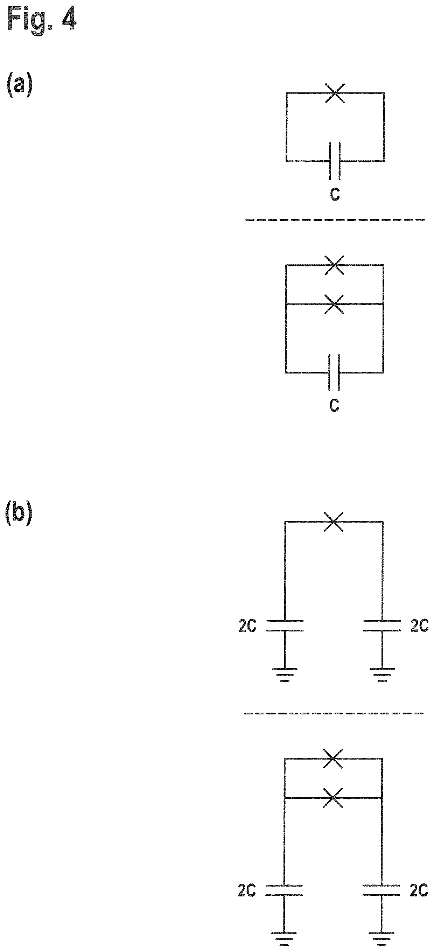

Fig. 4 is to exemplarily illustrate circuit parameters of an implementation in accordance with the invention as shown in Fig. 4(b) as compared to the ones of a conventional transmon circuit comprising a large capacitor to directly shunt the Josephson junction 1 as shown in Fig. 4(a). Standard parameters of the conventional circuit are C = 80 fF, effective Josephson induction is 13 nH, and operating frequency is 5 GHz.

In the implementation according to the invention to have the same shunt capacitance, each of the capacitances of the first and second electrode regions to ground has the value 2C. When implemented with coplanar waveguides, on Si with S/W = 2 ratio for the CPW, the capacitance per unit length is 0.18 nF/m, the inductance per unit length is 400 nH/m. As a consequence, a total of 2 mm of waveguide for the qubit is needed (1 mm per capacitance to ground). Waveguides also have inductance, but the total inductance of the waveguide is small, only around 6% of the Josephson inductance, which is good.

### List of Reference Signs

- 1: Josephson junction region
- 2: SQUID-loop
- 3, 3': capacitor plates / first and second electrode regions
- 4: opposite capacitor plates / common ground electrode region
- 5, 5': intermediate section
- 6, 6': intermediate section
- 10, 11: legs
- 12: connecting portion
- 13: bisector curve
- 13a, 13b: outermost point
- 14: circle / central portion
- 15: gap

## Claims

1. Planar electrically floating qubit circuit structure comprising:
a Josephson junction region (1) including first and second weakly coupled superconductors;
first and second electrode regions (3, 3') galvanically coupled to said first and second superconductors, respectively; and
a ground electrode region (4);
**characterised in that**
the series capacitance of said first and second electrode regions (3, 3') to said ground electrode region (4) is greater than the self-capacitance of said Josephson junction region (1).

2. Circuit structure according to claim 1, wherein the surface area of said Josephson junction region (1) is less than the surface area of each of said first and second electrode regions (3, 3').

3. Circuit structure according to anyone of the preceding claims, wherein the geometrical arrangement of said first and second electrode regions (3, 3') is centrally symmetric with respect to the centroid of the surface area of said Josephson junction region (1).

4. Circuit structure according to anyone of the preceding claims, wherein each of said first and second electrode regions (3, 3') is in the shape of a continuous strip of essentially uniform width that extends between a connecting portion (12) thereof, that is located adjacent to said Josephson junction region (1) for galvanic connection thereto and at least one free end portion thereof, that is located remote from said Josephson junction region (1).

5. Circuit structure according to claim 4, wherein said strip has first and second free end portions with said connecting portion (12) of said strip (10, 11) located half-way therebetween.

6. Circuit structure according to claim 5, wherein the directions of extension of said strip from its connecting portion (12) to its first and second free end portions are essentially mutually orthogonal.

7. Circuit structure according to anyone of claims 4 to 6, wherein said direction of extension of said strip is a mean linear direction, said strip meandering (5, 5'; 6, 6') about said linear direction between said connecting portion (12) thereof and each one of said free end portions thereof.

8. Circuit structure according to anyone of claims 1 to 7, wherein said ground electrode region (4) and each of said first and second electrode regions (3, 3') is arranged so as to form a microstrip waveguide.

9. Circuit structure according to anyone of claims 1 to 7, wherein said ground electrode region (4) and each of said first and second electrode regions (3, 3') is arranged so as to form a coplanar waveguide.

10. Circuit structure according to anyone of the preceding claims, wherein said qubit circuit is a fixed-frequency transmon or is a tuneable transmon.

11. Circuit structure according to anyone of the preceding claims in combination with a tuneable coupler and another circuit structure according to anyone of the preceding claims, wherein at least one of said first and second electrode regions (3, 3') of the one of said circuit structures is capacitively coupled to the tuneable coupler that is capacitively coupled to one of said first and second electrode regions (3, 3') of the other one of said circuit structures.

## Patentansprüche

1. Planare, elektrisch schwebende Qubit-Schaltungsstruktur, die Folgendes umfasst:
einen Josephson-Übergangsbereich (1), der einen ersten und einen zweiten schwach gekoppelten Supraleiter enthält;
einen ersten und einen zweiten Elektrodenbereich (3, 3'), die galvanisch mit dem jeweiligen ersten und zweiten Supraleiter gekoppelt sind; und
einen Masseelektrodenbereich (4);
**dadurch gekennzeichnet, dass** die Serienkapazität des ersten und des zweiten Elektrodenbereichs (3, 3') zu dem Masseelektrodenbereich (4) größer ist als die Eigenkapazität des Josephson-Übergangsbereichs (1).

2. Schaltungsstruktur nach Anspruch 1, wobei der Oberflächenbereich des Josephson-Übergangsbereichs (1) kleiner ist als der Oberflächenbereich jedes der ersten und zweiten Elektrodenbereiche (3, 3').

3. Schaltungsstruktur nach einem der vorhergehenden Ansprüche, wobei die geometrische Anordnung des ersten und des zweiten Elektrodenbereichs (3, 3') in Bezug auf den Mittelpunkt des Oberflächenbereichs des Josephson-Übergangsbereichs (1) zentral symmetrisch ist.

4. Schaltungsstruktur nach einem der vorhergehenden Ansprüche, wobei jeder des ersten und des zweiten Elektrodenbereichs (3, 3') die Form eines fortlaufenden Streifens von im Wesentlichen gleichmäßiger Breite aufweist, der sich zwischen einem Verbindungsabschnitt (12) desselben, der angrenzend an den Josephson-Übergangsbereich (1) zur galvanischen Verbindung mit diesem angeordnet ist, und zumindest einem freien Endabschnitt desselben, der entfernt von dem Josephson-Übergangsbereich (1) angeordnet ist, erstreckt.

5. Schaltungsstruktur nach Anspruch 4, wobei der Streifen einen ersten und einen zweiten freien Endabschnitt aufweist, wobei der Verbindungsabschnitt (12) des Streifens (10, 11) auf halbem Wege dazwischen angeordnet ist.

6. Schaltungsstruktur nach Anspruch 5, wobei die Erstreckungsrichtungen des Streifens von seinem Verbindungsabschnitt (12) zu seinem ersten und zweiten freien Endabschnitt im Wesentlichen orthogonal zueinander sind.

7. Schaltungsstruktur nach einem der Ansprüche 4 bis 6, wobei es sich bei der Erstreckungsrichtung des Streifens um eine mittlere lineare Richtung handelt und der Streifen zwischen seinem Verbindungsabschnitt (12) und jedem seiner freien Endabschnitte mäanderförmig (5, 5'; 6, 6') mäandernd um diese lineare Richtung verläuft.

8. Schaltungsstruktur nach einem der Ansprüche 1 bis 7, wobei der Masseelektrodenbereich (4) und jeder des ersten und des zweiten Elektrodenbereichs (3, 3') so ausgerichtet sind, dass sie einen Mikrostreifenwellenleiter bilden.

9. Schaltungsstruktur nach einem der Ansprüche 1 bis 7, wobei der Masseelektrodenbereich (4) und jeder des ersten und des zweiten Elektrodenbereichs (3, 3') so ausgerichtet sind, dass sie einen koplanaren Wellenleiter bilden.

10. Schaltungsstruktur nach einem der vorhergehenden Ansprüche, wobei es sich bei der Qubit-Schaltung um ein Transmon mit fester Frequenz oder ein abstimmbares Transmon handelt.

11. Schaltungsstruktur nach einem der vorhergehenden Ansprüche in Kombination mit einem abstimmbaren Koppler und einer weiteren Schaltungsstruktur nach einem der vorhergehenden Ansprüche, wobei zumindest einer des ersten und des zweiten Elektrodenbereichs (3, 3') der einen der Schaltungsstrukturen kapazitiv mit dem abstimmbaren Koppler gekoppelt ist, der kapazitiv mit einem des ersten und des zweiten Elektrodenbereichs (3, 3') der anderen der Schaltungsstrukturen gekoppelt ist.

## Revendications

1. Structure de circuit qubit flottant électriquement planaire comprenant :
une région de jonction Josephson (1) comprenant des premier et deuxième supraconducteurs faiblement couplés,
des première et deuxième régions d'électrode (3, 3') respectivement couplées galvaniquement auxdits premier et deuxième supraconducteurs, et
une région d'électrode de masse (4) ;
**caractérisée en ce que** la capacité série entre lesdites première et deuxième régions d'électrode (3, 3') et ladite région d'électrode de masse (4) est supérieure à la capacité répartie de ladite région de jonction Josephson (1).

2. Structure de circuit selon la revendication 1, dans laquelle l'aire de ladite région de jonction Josephson (1) est inférieure à l'aire de chacune desdites première et deuxième régions d'électrode (3, 3').

3. Structure de circuit selon l'une quelconque des revendications précédentes, dans laquelle l'agencement géométrique desdites première et deuxième régions d'électrode (3, 3') est centralement symétrique par rapport au centroïde de l'aire couverte par ladite région de jonction Josephson (1).

4. Structure de circuit selon l'une quelconque des revendications précédentes, dans laquelle chacune desdites première et deuxième régions d'électrode (3, 3') se présente sous la forme d'une bande continue de largeur essentiellement uniforme qui s'étend entre une partie de connexion (12) de celle-ci, adjacente à ladite région de jonction Josephson (1) pour une connexion galvanique à celle-ci, et au moins une partie d'extrémité libre de celle-ci, qui est distante de ladite région de jonction Josephson (1).

5. Structure de circuit selon la revendication 4, dans laquelle ladite bande comporte des première et deuxième parties d'extrémité libres, ladite partie de connexion (12) de ladite bande (10, 11) étant située à mi-chemin entre elles.

6. Structure de circuit selon la revendication 5, dans laquelle les directions d'étendue de ladite bande, de sa partie de connexion (12) jusqu'à ses première et deuxième parties d'extrémité libres, sont essentiellement mutuellement orthogonales.

7. Structure de circuit selon l'une quelconque des revendications 4 à 6, dans laquelle ladite direction d'étendue de ladite bande est une direction linéaire moyenne, ladite bande serpentant (5, 5' ; 6, 6') autour de ladite direction linéaire entre ladite partie de connexion (12) de celle-ci et chacune desdites parties d'extrémité libres de celle-ci.

8. Structure de circuit selon l'une quelconque des revendications 1 à 7, dans laquelle ladite région d'électrode de masse (4) et chacune desdites première et deuxième régions d'électrode (3, 3') sont agencées de manière à former un guide d'ondes microruban.

9. Structure de circuit selon l'une quelconque des revendications 1 à 7, dans laquelle ladite région d'électrode de masse (4) et chacune desdites première et deuxième régions d'électrode (3, 3') sont agencées de manière à former un guide d'ondes coplanaire.

10. Structure de circuit selon l'une quelconque des revendications précédentes, dans laquelle ledit circuit qubit est un transmon à fréquence fixe ou est un transmon accordable.

11. Structure de circuit selon l'une quelconque des revendications précédentes en combinaison avec un coupleur accordable et une autre structure de circuit selon l'une quelconque des revendications précédentes, dans laquelle au moins l'une desdites première et deuxième régions d'électrode (3, 3') de l'une desdites structures de circuit est couplée de manière capacitive au coupleur accordable qui est couplé de manière capacitive à l'une desdites première et deuxième régions d'électrode (3, 3') de l'autre desdites structures de circuit.
